# EUROPÄISCHE PATENTANMELDUNG

(11) **EP 1 968 115 A2**
(43) Veröffentlichungstag der Anmeldung: **10.09.2008**
(21) Anmeldenummer: 08003723.7
(22) Anmeldetag: 28.02.2008
(51) Int. Cl.: H01L 25/075

(54) **Lichtemissionsvorrichtung**

(30) Priorität: 09.03.2007 DE 102007011637
(71) Anmelder: Ivoclar Vivadent AG, 9494 Schaan (LI)
(72) Erfinder: Die Erfindernennung liegt noch nicht vor
(74) Vertreter: Baronetzky, Klaus

(57) **Zusammenfassung**

Die Erfindung betrifft eine Lichtemissionsvorrichtung, mit mindestens zwei lichtemittierenden Halbleiterchips und einem Substrat. Mindestens ein erster Halbleiterchip (12) ist auf dem Substrat und auf dem ersten Halbleiterchip (12) ist ein zweiter Halbleiterchip (14) angebracht.

## Beschreibung

Die Erfindung betrifft eine Lichtemissionsvorrichtung, gemäß dem Oberbegriff von Anspruch 1.

Es sind zahlreiche Versuche unternommen wurden, die Emissionsstärke von Leuchtdioden zu erhöhen. So ist es vorgeschlagen worden, mehrere, recht kleine Leuchtdioden-Halbleiterchips eng benachbart zueinander anzuordnen, um zu einer höhren Lichtausbeute zu gelangen. Problem hierbei ist natürlich die Wärmeableitung, denn durch die eng benachbarte Anordnung der Halbleiterchips werden diesen bei entsprechender Leistung recht heiß.

Man hat daher versucht, die Lichtemission von der Wärmestrahlung nach Möglichkeit zu trennen und die Wärmestrahlung schwerpunktmäßig nach hinten, die Lichtemission hingegen nach vorne abstrahlen zu lassen.

Aus derartigen Überlegungen ist auch die sogenannte Flip-Chip-Technik entstanden, bei der ein oder mehrere Halbleiterchips auf einen lichtdurchlässigen Substrat, das beispielsweise aus Saphir oder dergleichen sein kann, angebracht sind.

Auf der dem Saphir abgewandten Seite des Chips oder der Chips erstreckt sich eine Reflektorschicht, beispielsweise aus Silber, wobei sowohl die Kontaktierung als auch die Wärmeableitung über recht dicke Pfosten, sogenannte Bumps, erfolgt, die den Chip in geeigneter Weise kontaktieren.

Bei dieser Lösung soll dann nach Möglichkeit möglichst viel Wärme nach hinten abgeführt werden, während dass Licht, durch die silberne Reflexionsschicht verstärkt, die Lichtemissionsvorrichtung durch das Saphir-Substrat nach vorne verlassen soll.

Auch ist man seit längerem bestrebt, den optischen Wirkungsgrad von Lichtemissionsvorrichtungen zu erhöhen. Hierzu werden meist Kombinationen von Sammellinsen und Reflektoren eingesetzt, die das emittierte Licht bündeln, und die Erzeugung von Fehllicht und Streulicht reduzieren sollen.

In neuerer Zeit ist es beispielsweise gemäß der nicht vorveröffentlichten deutschen Patentanmeldung 10 2006 015 377 vorgeschlagen worden, einen Halbleiter-Strahlungsquelle mit einer Mehrzahl von LED-Chips auszubilden, die über eine eng herangeführte Printplatte kontaktiert werden, wobei ein Reflektor in Kombination mit einer Sammellinse eine möglichst hohe Lichtausbeute sicherstellen soll, aber dennoch die erzeugte Wärme gut abgeführt werden soll.

Zwar ist eine derartige Halbleiter-Strahlungsquelle im Grunde bereits gut geeignet, wenn es gilt, eine möglichst hohe Lichtausbeute sicherzustellen. Es wäre jedoch wünschenswert, die Lichtausbeute noch weiter zu verbessern, ohne dass die Wärmeabgabe erhöht würde.

Daher liegt der Erfindung die Aufgabe zu Grunde, eine Lichtemissionsvorrichtung gemäß dem Oberbegriff von Anspruch 1 zu schaffen, die hinsichtlich der Lichtemission verbessert ist, ohne dass durch eine Erhöhung der elektrischen Leistung Probleme bei der Wärmeableitung entstehen.

Diese Aufgabe wird erfindungsgemäß durch Anspruch 1 gelöst. Vorteilhafte Weiterbildungen ergeben sich aus den Unteransprüchen.

Erfindungsgemäß besonders günstig ist es, dass durch die Stapelanordnung von beispielsweise im Winkel von 45° gegeneinander verdrehten LED-Chips eine zentralintensivierte Lichtemission erzeugbar ist. Die Fokussierung eines solchen zentralen Helligkeitspunktes fällt wesentlich leichter als bei einer flächigen Verteilung der Lichtemission, so dass die Lichtausbeute insgesamt sich deutlich erhöhen lässt.

Dies eröffnet ein erweitertes Anwendungsfeld für Lichtemissionsvorrichtungen, beispielsweise auch in der Dentaltechnik, wo es mit entsprechend konstruierten Lichthärtgeräten gelingt, gezielt bestimmte und noch nicht ausreichend durchgehärtete Bereiche einer polymerisierbaren Dentalrestauration rasch zu polymerisieren.

Überraschend lässt sich durch das gestapelte Anbringen von Chips die Lichtemission deutlich erhöhen, wobei die Tatsache ausgnutzt wird, dass der Chip selbst für Licht durchlässig ist. Die Durchlässigkeit ist bei den gleichen verwendeten Materialien besonders gut, nachdem dann dort die gleiche Gitterkonstante vorliegt. Erfindungsgemäß ist es vorgesehen, zwischen den Halbleiter-Chips des Chipstapels eine sehr dünne und lichtdurchlässige Klebeschicht auszubilden, die auch gut wärmeleitend ist und daher die Wärme der oberen Chips gut ableitet.

Erfindungsgemäß lässt sich auch die Tatsache ausnutzen, dass ein wesentlicher Teil der Lichtemission bei Halbleiterchips typischerweise über seitliche Lichtaustrittsflächen erfolgt. Diese sind bevorzugt so angeordnet, dass die Lichtemission schräg nach vorne nicht beeinträchtigt wird. Dies lässt sich beispielsweise dadurch erreichen, dass der Stapel der Halbleiterchips einen im Wesentlichen pyramidenförmigen Aufbau hat. Die je oberen Halbleiterchips springen je gegenüber den je unteren Halbleiterchips zurück, also sind zur optischen Achse hin nach einwärts versetzt. Hiermit einher geht eine Reduktion der Abmessungen des oberen Halbleiterchips, gegenüber dem je unteren Halbleiterchip, wobei die Reduktion bevorzugt in beide Richtungen erfolgt.

In an sich bekannter Weise können die Halbleiterchips quadratisch sein und als im Wesentlichen als dünne Plättchen ausgebildet sein. Halbleiterchips mit unterschiedlichen Abmessungen sind ohne weiteres erhältlich, so dass insofern auf handelübliche Bauteile zurückgegriffen werden kann, die sich erfindungsgemäß in besonders günstiger Weise kombinieren lassen.

Hierbei lässt sich auch die Tatsache ausnutzen, dass die Halbleiterchips typischerweise eine Lambertsche Abstrahlcharakteristik haben, die es ermöglicht, gerade bei Überlagerung mehrerer derartiger Abstrahlcharakteristiken, die voneinander in vertikaler Richtung, also in Richtung der Lichtemission, etwas beabstandet sind, die Lichtemission im Bereich der optischen Achse relativ zu vergrößern.

Erfindungsgemäß ist es damit möglich, den Anteil des direkt abgestrahlten Lichts gegenüber dem Anteil des reflektierten Lichts wesentlich zu erhöhen, so dass auch Reflektorfehler und dergleichen weniger ins Gewicht fallen.

In vorteilhafter Ausgestaltung der Erfindung ist es vorgesehen, dass mindestens eine nach oben weisende Fläche eines unteren Halbleiterchips von dem darauf befindlichen Halbleiterchips nicht abgedeckt ist und insofern frei bleibt. Diese Fläche dient einerseits der Lichtemission, andererseits wird hierdurch die Möglichkeit bereitgestellt, einen Anschlussfläche für das Bonden bereitzustellen, so dass pro Halbleiterchip mindestens zwei Anschlussflächen für die elektrische Versorgung der Halbleiterchips zur Verfügung stehen.

Erfindungsgemäß ist es vorgesehen, dass die untere Fläche für die Wärmeableitung geeignet ausgebildet ist. Hierzu ist der untere Halbleiterchip mindestens nicht kleiner und bevorzugt größer als der darüber befindliche Halbleiterchip. Soweit sich der darüber befindliche Halbleiterchip partiell über den darunter befindlichen Halbleiterchip hinauserstreckt, erfolgt dies in räumlich begrenztem Rahmen, wobei die Summe der frei tragenden Flächen des oberen Halbleiterchips bevorzugt weniger als 20% und insbesondere weniger als 10% der Gesamtfläche ausmachen sollten.

Es versteht sich, dass hier unter Halbleiterchip ein Die zu verstehen ist, bei dem auch mehrere elektrische Strukturen zusammengefasst sein können, die auch mit einer Mehrzahl von Anschlussflächen verbunden sein können.

Besonders günstig ist es, wenn oberhalb des obersten Halbleiterchips eine Sammellinse angebracht ist.

Hierdurch lässt sich die abgegebene Lichtstrahlung in beliebiger geeigneter Weise fokussieren, wobei auch die Einleitung des abgegebenen Lichts in ein Lichtleiter wie einen Lichtleitstab erfindungsgemäß ohne weiteres möglich ist.

Erfindungsgemäß bevorzugt ist es, wenn die Anordnung der Halbleiterchips frei von Reflektoren und Reflexionsschichten ist, abgesehen von einer Reflexionsschicht, die unterhalb des untersten Halbleiterchips angeordnet ist. Diese Reflexionsschicht reflektiert die nach unten abgegebene Strahlung im Wesentlichen vollständig und wirkt nach oben, wobei es bevorzugt ist, dass die Halbleiterchip-Anordnung von einem Ringreflektor umgeben ist, der die so reflektierte Strahlung zusätzlich nach vorne wirft und fokussiert.

Erfindungsgemäß ist es auch ohne weiteres möglich, die gestapelten Halbleiterchips so auszugestalten, dass sie Licht unterschiedlicher Wellenlängenbereiche emittieren. Hierzu lässt sich die Tatsache ausnutzen, dass jeder Halbleiterchip mit Anschlussflächen versehen ist. Die elektrische Ansteuerung kann damit unabhängig von einander erfolgen, so dass auch Farbwechsel ohne weiteres realisierbar sind.

Erfindungsgemäß wird bei den bevorzugten pyramidenförmigen Aufbau der Halbleiterchip-Anordnung auch der Effekt ausgenutzt, dass die Lichtemission und damit einhergehend die Wärmeentwicklung des untersten Halbleiterchips am größten ist. Die dort anfallende Wärme lässt sich aufgrund der unmittelbaren Montage auf einen gut wärmeleitenden Substrat bestens ableiten, während die eingebrachte Wärmemenge bei weiter oben angeordneten Halbleiterchips entsprechend deren geringeren Abmessungen auch geringer ist.

Nachdem erfindungsgemäß eine Kompaktanordnung von Halbleiterchips möglich ist, ist es bevorzugt, die Bereitstellung von Freiflächen für das Bonden auf einer Printplatte unmittelbar benachbart den Halbleiterchips vorzusehen. Hierzu weist das Substrat bevorzugt einen Vorsprung auf, auf dem der unterste Halbleiterchip angebracht ist, und bis an dessen Seitenfläche die Printplatte mit Ihrer Freifläche herangeführt ist.

In diesem Zusammenhang ist es günstig, wenn die Bauhöhe der Printplatte im Wesentlichen der Höhe des Substratsockels-Vorsprungs entspricht.

In einer weiteren vorteilhaften Ausgestaltung ist es vorgesehen, dass der zweite als relativ oberer Halbleiterchip eine nach oben weisende Fläche des ersten als relativ unterem Halbleiterchips frei lässt und dass mindestens die freigelassene Fläche des unteren Halbleiterchips und mindestens eine Fläche des oberen Halbleiterchips lichtemittierend ist, wobei der untere Halbleiterchip auf dem Substrat angebracht ist.

In einer weiteren vorteilhaften Ausgestaltung ist es vorgesehen, dass sich seitliche Lichtemissionsflächen seitlich an den Chips erstrecken, die zueinander versetzt sind.

In einer weiteren vorteilhaften Ausgestaltung ist es vorgesehen, dass sich eine seitliche Lichtemissionsfläche des oberen Halbleiterchips, bezogen auf eine seitliche Lichtemissionsfläche des unteren Halbleiterchips, zur Mitte des Halbleiterchips hin verlagert, erstreckt.

In einer weiteren vorteilhaften Ausgestaltung ist es vorgesehen, dass die Halbleiterchips im Wesentlichen pyramidenförmig zueinander aufgebaut sind.

In einer weiteren vorteilhaften Ausgestaltung ist es vorgesehen, dass die Halbleiterchips für emittierte Strahlung mindestens teilweise durchlässig sind.

In einer weiteren vorteilhaften Ausgestaltung ist es vorgesehen, dass die Lichtemissionsvorrichtung einen Reflektor aufweist, der unterhalb des unteren Halbleiterchips angebracht ist, und dass zwischen dem unteren, einem mittleren und dem und oberen Halbleiterchip kein Reflektor vorgesehen ist.

In einer weiteren vorteilhaften Ausgestaltung ist es vorgesehen, dass die Lichtemissionsvorrichtung eine Mehrzahl von Halbleiterchips aufweist und ein Reflektor unterhalb des untersten Halbleiterchips angebracht ist, der sich insbesondere seitlich über den Halbleiterchip hinaus erstreckt.

In einer weiteren vorteilhaften Ausgestaltung ist es vorgesehen, dass die Halbleiterchips über eine reflexionsfreie Klebeschicht miteinander verbunden sind, die eine Wärmeleitfähigkeit aufweist, die etwa so groß wie die Wärmeleitfähigkeit der Halbleiterchips ist, wobei die Stärke der Klebeschicht insbesondere weniger als 100 µm und bevorzugt weniger als 50 µm beträgt.

In einer weiteren vorteilhaften Ausgestaltung ist es vorgesehen, dass mehrere Halbleiterchips, die Licht unterschiedlicher spektraler Wellenlängen ausstrahlen, aufeinander angeordnet sind.

In einer weiteren vorteilhaften Ausgestaltung ist es vorgesehen, dass die Halbleiterchips mindestens teilweise zueinander elektrisch in Reihe geschaltet sind.

In einer weiteren vorteilhaften Ausgestaltung ist es vorgesehen, dass die Halbleiterchips mindestens teilweise zueinander elektrisch parallel geschaltet sind.

In einer weiteren vorteilhaften Ausgestaltung ist es vorgesehen, dass die Halbleiterchips auf ihrer Oberseite im Bereich der freigelassenen Fläche mindestens ein elektrisches Anschlussfeld aufweisen.

In einer weiteren vorteilhaften Ausgestaltung ist es vorgesehen, dass das Substrat elektrisch isolierend ist und eine Reflexionsschicht trägt.

In einer weiteren vorteilhaften Ausgestaltung ist es vorgesehen, dass der unterste Halbleiterchip auf einen elektrisch mindestens halbleitfähigen Substrat aufgebracht ist und dass eine elektrische Anschlußfläche des untersten Halbleiterchip durch das Substrat gebildet ist.

In einer weiteren vorteilhaften Ausgestaltung ist es vorgesehen, dass der obere Halbleiterchip kleiner als der untere Halbleiterchip ist, wobei insbesondere der Größenunterschied etwa der doppelten Stärke jedes Halbleiterchips entspricht.

In einer weiteren vorteilhaften Ausgestaltung ist es vorgesehen, dass das Substrat einen Vorsprung aufweist, dessen Abmessungen im Wesentlichen den Abmessungen des unteren Halbleiterchips entsprechen und auf dem der untere Halbleiterchip angebracht ist.

In einer weiteren vorteilhaften Ausgestaltung ist es vorgesehen, dass ein Zusatzreflektor, insbesondere ein Ringreflektor, die aufeinander angebrachten Halbleiterchips umgibt, dessen Ausrichtung in an sich bekannter Weise schräg oder parabolisch ist und der die seitliche Lichtemission der Halbleiterchips nach vorne reflektiert.

In einer weiteren vorteilhaften Ausgestaltung ist es vorgesehen, dass eine Sammellinse vor den Halbleiterchips angebracht ist, die insbesondere auf dem Reflektor abgestützt ist.

In einer weiteren vorteilhaften Ausgestaltung ist es vorgesehen, dass der Raum zwischen den Halbleiterchips und der Unterseite der Sammellinse von einer durchsichtigen oder durchscheinende, flüssige oder gelförmige lichtdurchlässigen Substanz, insbesondere Silikongel, gefüllt ist.

In einer weiteren vorteilhaften Ausgestaltung ist es vorgesehen, dass die elektrischen Anschlussflächen Freiflächen einer Printplatte benachbart sind, mit welchen Sie elektrisch über Bonddrähte verbunden sind.

In einer weiteren vorteilhaften Ausgestaltung ist es vorgesehen, dass sich eine Printplatte die Halbleiterchips mindestens teilweise umgebend seitlich neben diesen erstreckt und insbesondere mit Leiterbahnen unterhalb eines Ringreflektors verläuft.

Weitere Vorteile, Einzelheiten und Merkmale ergeben sich aus der nachfolgenden Beschreibung zweier Ausführungsbeispiele der Erfindung anhand der Zeichnung.

Es zeigen:
- Fig. 1: eine schematische Ansicht einer Ausführungsform einer erfindungsgemäßen Halbleiter-Strahlungsquelle in perspektivischer Darstellung;
- Fig. 2: eine Fig. 1 entsprechende Ansicht einer weiteren möglichen Ausführungsform einer Halbleiter-Strahlungsquelle;
- Fig. 3: eine teilweise geschnittene, ebenfalls perspektivische Darstellung einer Halbleiterstrahlungsquelle in der Ausführungsform gemäß Fig. 2, wobei die Darstellung die Ausführungsform in eingebauten Zustand zeigt;
- Fig. 4: eine schematische Ansicht einer weiteren Ausführungsform in Draufsicht;
- Fig. 5: eine schematische Ansicht noch einer weiteren Ausführungsform in Draufsicht;
- Fig. 6: eine schematische Ansicht einer weiteren Ausführungsform in Draufsicht;
- Fig. 7: eine schematische Ansicht einer weiteren Ausführungsform in Draufsicht;
- Fig. 8: einen schematischen Strahlenverlauf des Lichtes der Ausführungsform gemäß Fig. 1 in Schnittdarstellung; und
- Fig. 9: eine schematische Ansicht einer Ausführungsform der Lichtemissionsvorrichtung in auf dem Substrat angebrachten Zustand.

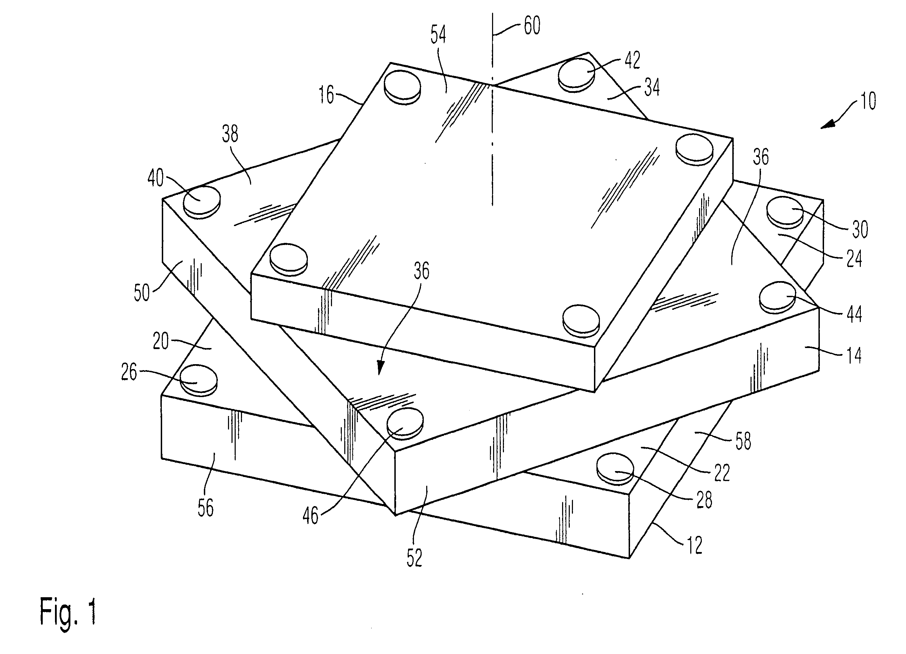

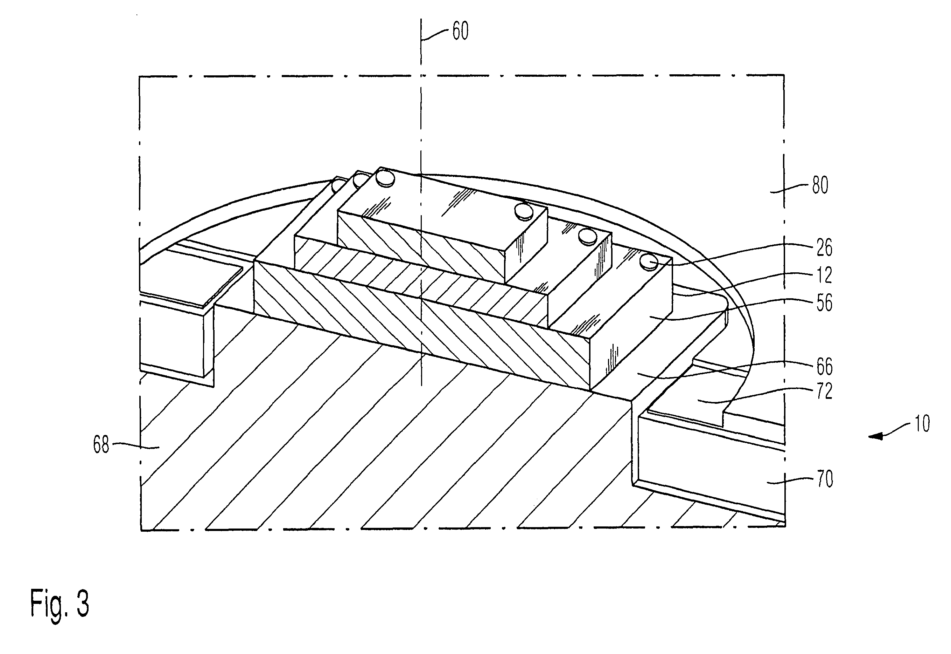

Aus Fig. 1 ist eine erfindungsgemäße Lichtemissionsvorrichtung 10 in einer Ausführungsform ersichtlich. Diese Lichtemissionsvorrichtung 10 weist mehrere Halbleiterchips auf, nämlich einen unteren Halbleiterchip 12, einen mittleren Halbleiterchip 14 sowie einen oberen Halbleiterchip 16. Hierbei ist der untere Halbleiterchip 12, der auch als erster Halbleiterchip bezeichnet werden kann, auf einen Substrat angebracht, das aus Fig. 3 beispielhaft ersichtlich ist.

Das Substrat kann in beliebiger geeigneter Weise ausgestaltet sein. Bevorzugt ist es wärmeableitend und besonders bevorzugt metallisch. Es ist aber auch möglich, bei einer Lösung mit geringerer Leistung ein Kunststoff-Gießmaterial als Substrat verwenden, das dann die räumliche Anordnung der Halbleiterchips fixiert.

In dem dargestellten Ausführungsbeispiel ist der erste oder untere Halbleiterchip 12 als Plättchen ausgebildet, das eine im Wesentlichen quadratische Quaderform hat. Derartige Halbleiterchips oder LED-Chips sind im Handel ohne weiteres erhältlich.

Im dargestellten Ausführungsbeispiel weisen der untere Halbleiterchip 12 und der mittlere Halbleiterchip 14 ein Verhältnis zwischen Kantenlänge und Stärke von etwa 8:1 auf. Sie sind gleich groß und aufeinandergelegt, jedoch gegeneinander verdreht. Die Verdrehung erfolgt in einem Winkel von etwa 45°, wobei jedoch auch ein Drehwinkel von 30° oder 60° ohne weiteres möglich wäre.

Durch die Verdrehung belässt der mittlere Halbleiterchip 14 vier dreieckförmige Flächen als freigelassene Flächen, wobei die Flächen 20, 22 und 24 aus Fig. 1 ersichtlich sind. Die dort verbleibende Fläche reicht aus, um je eine elektrische Anschlussfläche 26, 28 und 30 bereitzustellen, die je recht weit außen und kreisförmig vorgesehen sind und für das Bonden vorbereitet sind.

Bei dem dargestellten Ausführungsbeispiel sind pro Chip vier Anschlussflächen vorgesehen, und der Chip trägt insbesamt drei unabhängig voneinander ansteuerbare Strukturen, die Licht emittieren, so dass beliebige Ansteuerungen möglich sind.

Alternativ kann es auch vorgesehen sein, lediglich zwei Strukturen vorzusehen, die dann elektrisch voneinander trennbar sind und je mit einem Anschlussflächenpaar verbunden sind.

In dem dargestellten Ausführungsbeispiel ist der obere Halbleiterchip 16 kleiner als der mittlere und untere Halbleiterchip 14 und 12.

Sein Kantenlängen/Stärken-Verhältnis beträgt ebenfalls etwa 8:1, so dass er auch dünner als die beiden anderen Chips 12 und 14 ist.

Er ist gegenüber dem mittleren Halbleiterchip 14 erneut um 45° verdreht, so dass er sich kantenparallel zu dem unteren Halbleiterchip 12 erstreckt. Durch diese Anordnung entstehen weitere freigelassene Flächen 32, 34, 36 und 38, die je einen dreieckförmigen Aufbau haben und auch der Kontaktierung über entsprechende Anschlussflächen 40, 42, 44 und 46 dienen.

Der obere Halbleiterchip 16 ist so groß, dass er einen wesentlichen Teil des mittleren Halbleiterchips 14 abdeckt, beispielsweise 70% seiner Fläche.

Der mittlere Halbleiterchip 14 emittiert Licht zum einen an seinen seitlichen Emissionsflächen, wobei die Emissionsflächen 50 und 52 aus Fig. 1 ersichtlich sind, zu anderen an seiner Unterseite, aber auch zu einem großen Teil an seiner Oberseite.

Das unterhalb des oberen Halbleiterchips 16 emittierte Licht durchtritt diesen und verstärkt das auf der Oberseite 54 des oberen Halbleiterchips 16 emittierte Licht insofern. Hierbei lässt sich die Tatsache günstig ausnutzen, dass die Stärke des oberen Halbleiterchips 16 etwas geringer als diejenige der beiden anderen Halbleiterchips 12 und 14 ist, dadurch wird die Dämpfung beim Durchtreten des betreffenden Chips 16 geringer.

Ein entsprechendes Lichtemissions- und Durchtrittsverhalten zeigt auch die Stapelung des mittleren Halbleiterchips auf dem unteren Halbleiterchips 12. Dementsprechend durchtritt das von der Oberseite des unteren Halbleiterchips 12 emittierte Licht sowohl den mittleren Halbleiterchip 14 als auch den oberen Halbleiterchip 16, soweit es nicht im Bereich der Flächen 20 bis 24 emittiert wird.

Auch hier erfolgt eine zusätzliche Lichtabgabe an den seitlichen Emissionsflächen, wobei aus Fig. 1 die Emissionsflächen 56 und 58 ersichtlich sind.

Bevorzugt werden Halbleiterchips mit kugeliger Abstrahlcharakteristik verwendet. Die Abstrahlcharakteristiken der Lichtemissionsvorrichtung, die aus den drei Halbleiterchips 12, 14 und 16 gebildet ist, ergibt sich im Wesentlichen als die rechnerische Aufsummierung der abgegebenen Lichtstärken, betrachtet über die Winkelabweichung von der optischen Achse 60. Diese idealisierte Abstrahlcharakteristik, die ein an eine Keule angenähertes Verhalten zeigt, wird in der Praxis durch die Strahlungsabsorption der Lichtemission der unteren Halbleiterchips durch die oberen Halbleiterchips gedämpft. Bei Materialgleichheit ist die Dämpfung jedoch überraschend ausgesprochen gering, was insbesondere wohl auf die Übereinstimmung der Gitterkonstanten zurückzuführen ist.

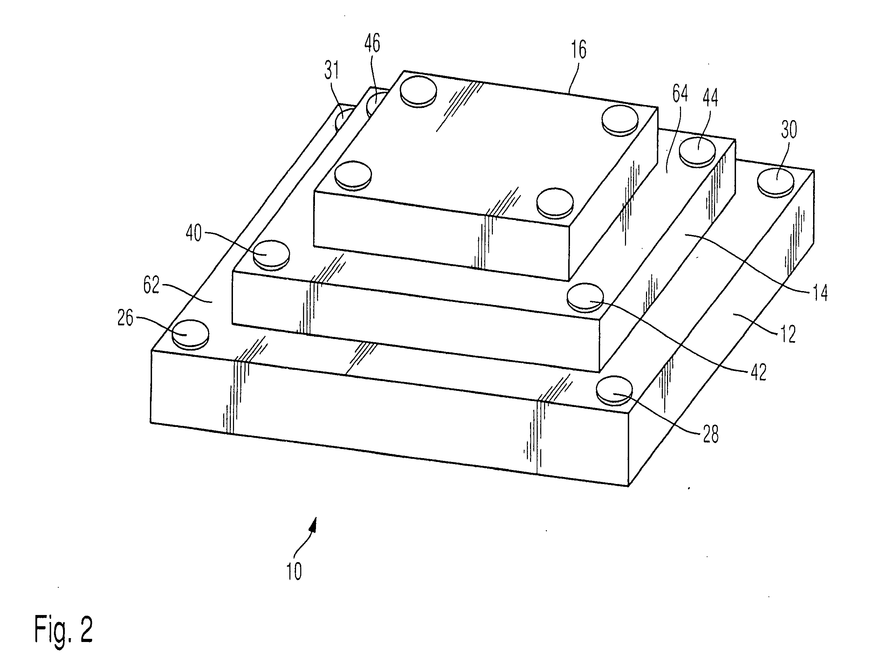

Aus Fig. 2 ist zu erläuternden Zwecken eine modifizierte Ausführungsform Lichtemissionsvorrichtung 10 ersichtlich. Dort wie auch in den übrigen Figuren weisen gleiche Bezugszeichen auf gleiche oder entsprechende Teile hin. Bei der Ausführungsform gemäß Fig. 2 sind alle Lichtleiterchips 12, 14 und 16 zueinander pyramidenförmig aufgebaut. Der Halbleiterchip 12 ist der größte und ist auf dem Substrat in Wärmeleitverbindung angebracht. Auf ihm ist der mittlere Halbleiterchip 14 aufgebracht, wobei er kleiner als der Halbleiterchip 12 ist.

Durch die Abmessungsunterschiede entsteht ein umlaufender freier Rand 62, dessen Breite im Wesentlichen der Stärke des Halbleiterchips 14 entspricht. Die Anschlussflächen 26, 28, 30 und 31 des unteren Halbleiterchips 12 sind wiederum in den Ecken angebracht, wobei entsprechendes auch für die Anschlussflächen 40 bis 46 des mittleren Halbleiterchips 14 und die Anschlussflächen des oberen Halbleiterchips 16 gilt.

Nachdem der obere Halbleiterchip 16 noch kleiner als der mittlere Halbleiterchip 14 ist und ebenfalls auf diesem angebracht ist, entsteht auch dort ein umlaufender Rand 64, dessen Breite wiederum der Stärke des Halbleiterchips 16 entspricht.

Durch diese Anordnung und Ausgestaltung ergibt sich insgesamt ein Pyramidenstumpf mit einem Pyramidenwinkel von etwa 45°.

Die Chips 12 bis 14 sind je in thermischen Kontakt aufeinander aufgebracht. Dies kann beispielsweise durch eine sehr dünne Klebeschicht realisiert sein, die den Wärmeübergang noch verbessert.

Aus Fig. 3 ist eine entsprechende Lichtemissionsvorrichtung 10 in geschnittenem Zustand und eingebaut ersichtlich. Die Lichtemissionsvorrichtung 10 ist auf einem Substrat 66 angebracht, das beispielsweise aus Kupfer besteht und einen Sockelvorsprung 68 hat. Der Sockelvorsprung 68 weist größere Abmessungen als der untere Halbleiterchip 12 auf. An ihn grenzt eine Printplatte 70 an, die Freiflächen 72 von Leiterbahnen trägt, die der Kontaktierung der verschiedenen Anschlussflächen dienen.

Beispielsweise kann die Anschlussfläche 28 über einen nicht dargestellten Bonddraht mit der Freifläche 72 verbunden sein.

Auf der Printplatte abgestützt ist ein Ringreflektor 80 als Zusatzreflektor, der die Lichtemissionsvorrichtung ringförmig umgibt. Der Ringreflektor 80 weist in an sich bekannter Weise eine schräg nach innen weisende Innenfläche auf, die aus den seitlichen Emissionsflächen, beispielsweise der Emissionsfläche 56, austretendes Licht nach vorne, also in Richtung der optischen Achse 60, reflektiert.

Zwischen dem Sockelvorsprung 68 und dem unteren Halbleiterchip 12 ist darüberhinaus ein Reflektor vorgesehen, der aus der zeichnerischen Darstellung nicht ersichtlich ist und das dort auftreffende Licht ebenfalls nach vorne wirft.

Da die aktive Schicht einer LED eine Strahlungsquelle darstellt, die nach dem Lambertschen Gesetz im Idealfall gleichmäßig Licht in alle Richtungen abstrahlt, ist es erfindungsgemäß vorgesehen, das Licht, das nicht direkt nach vorn abgegeben wird, zum Lichtleiter zu reflektieren. Durch die bereits vorstehend genannten Reflektoren ist es insofern möglich, auch das Licht, das beispielsweise von den in Fig. 1 dargestellten dreieckförmigen Flächen 32, 34, 36 und 38 sowohl seitlich als auch nach hinten - also in Richtung des Substrats - abgestrahlt wird, nach vorn zu werfen. Damit wird eine weitere Verbesserung der Lichtausbeute aus den LED-Chips erreicht. Da die dreiecksförmigen Flächen regelmäßig nur auf einer Seite (meist auf der dem Substrat abgewandten Seite) mit den elektrischen Anschlussflächen für das Bonden, den sogenannten Bondinseln, versehen sind, sind die dem Substrat zugewandte Seite sowie die seitlichen Kanten freiliegend und können insofern ungehindert Licht emittieren. Diese zusätzliche Strahlung wird mithilfe der oben genannten Reflektoren dem Lichtleiter zugeführt.

Bei zwei gleich großen übereinander liegenden LED-Chips, die mit 45° gegeneinander verdreht sind, machen beispielsweise die über den jeweils anderen LED-Chip überstehenden Dreiecksflächen ca. 17 % der Chipgesamtfläche aus. Diese Fläche steht für die rückwärtige Emission von Strahlung vollständig, für die Emission von Strahlung nach vorn nur um die elektrischen Anschlussflächen verringert, die zum Bonden benötigt werden, zur Verfügung. Das zeigt, dass ein recht beträchtlicher Teil der Strahlung über die überstehenden Dreiecksflächen abgegeben wird. Diese Strahlung muss nicht den jeweils anderen LED-Chip durchlaufen und unterliegt daher auch nicht der durch den anderen LED-Chip verursachten Dämpfung durch eine ggfs. abweichende Gitterkonstante, durch Brechung an den Chipgrenzflächen oder Totalreflexion u.ä.

Auch wenn der obere LED-Chip 16 in Fig. 1 durch seine relativ zu den beiden darunterliegenden Chips 12 und 14 geringere Größe den mittleren Chip 14 nur um einen geringeren Betrag überragt als der mittlere Chip 14 den unteren Chip 12, so kommt doch auch die von Chip 16 seitlich nach hinten abgegebene Lichtstrahlung trotzdem der durch die genannten Reflektoren gesteigerten Lichtausbeute des gesamten LED-Stapels zugute. Mit gestapelten LEDs nach dem Stand der Technik wäre die erreichbare Lichtausbeute signifikant geringer als die mit der vorliegenden Erfindung erreichbare.

Eine weitere Steigerung der Lichtausbeute des erfindungsgemäßen LED-Stapels kann dadurch erreicht werden, dass die elektrischen Anschlussflächen der einzelnen LED-Chips, relativ zur gesamten Fläche der durch die Verdrehung der einzelnen Chips gebildeten Dreiecksflächen, so klein wie möglich gehalten werden, ohne die Kontaktsicherheit beim Bonden zu gefährden, d. h., die fertigungsbedingte maximal tolerierbare Abweichung beim Positionieren der LED-Chips während des Bondvorganges zu unterschreiten. Erfindungsgemäß wird eine besonders exakte Positionierung mit modernen Fertigungsautomaten vorgenommen, sodass die nutzbare Chipfläche vergrößert ist.

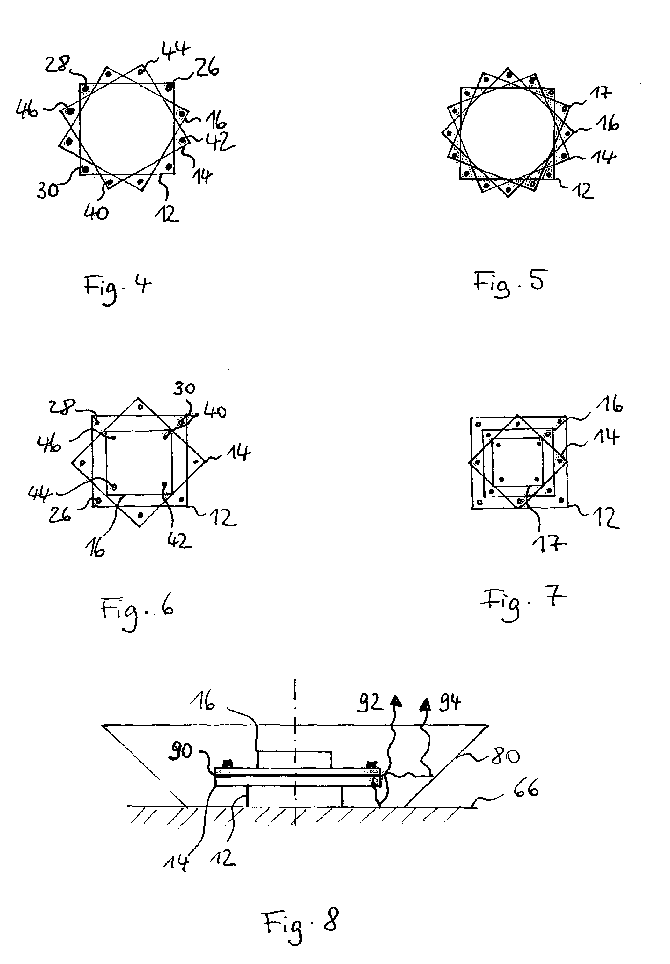

Fig. 4 zeigt eine weitere Ausführungsform, bei der die drei LED-Chips 12, 14 und 16 jeweils um 30° gegeneinander verdreht sind. Bei der in Fig. 4 dargestellten Ausführungsform sind alle drei LED-Chips 12, 14, 16 flächengleich. D.h., sowohl LED-Chip 14 als auch LED-Chip 16 überragen LED-Chip 12 jeweils mit gleich großen Dreiecksflächen, wobei jedoch die Ecken von Chip 14 entgegen dem Uhrzeigersinn gegenüber den Ecken von LED-Chip 12 und die Ecken von LED-Chip 16 im Uhrzeigersinn gegenüber den Ecken von LED-Chip 12 verdreht sind. Dadurch wird erreicht, dass trotz gleich großer LED-Chipflächen der drei dargestellten LED-Chips 12, 14, 16 die überstehenden Dreiecksflächen eines der LED-Chips (bspw. Chip 14) jeweils die beiden anderen LED-Chips (dementsprechend die Chips 12 und 16) überragen. Dies wäre bei drei LED-Chips, die jeweils um 45° gegeneinander verdreht sind, nicht möglich. Insofern kann durch die in Fig. 4 dargestellte Ausführungsform eine weitere Steigerung der Lichtausbeute des LED-Stapels erreicht werden, da die LED-Chips 12, 14, 16 über die überstehenden Dreiecksflächen frei nach hinten bzw. vorn abstrahlen können, ohne durch die überstehenden Dreiecksflächen eines anderen LED-Chips des Stapels behindert bzw. "abgeschattet" zu werden. Auch wird durch die in Fig. 4 dargestellte Ausführungsform möglich, drei gleich große LED-Chips übereinander zu stapeln, und die elektrischen Anschlussflächen trotzdem jeweils an den Ecken der einzelnen LED-Chips vorzusehen, da die Ecken durch die Verdrehung der Chips gegeneinander im LED-Stapel freiliegend bleiben, also nicht durch einen anderen LED-Stapel verdeckt werden.

Es sind darüberhinaus selbstverständlich auch Ausführungsformen möglich, bei denen die einzelnen LED-Chips zwar auch jeweils um beispielsweise 30° gegeneinander verdreht sind, die einzelnen Chips jedoch unterschiedliche Größen aufweisen. Damit würden sich ggfs. die für das rückwärtige Abstrahlen wirksamen Dreiecksflächen einzelner LED-Chips verkleinern, es könnte aber beispielsweise durch die unterschiedlichen Chipgrößen eine Anpassung der abgegebenen Lichtleistung der einzelnen LED-Chips relativ zu den anderen Chips des LED-Stapels erreicht werden. Auch die erzeugte und somit abzuführende Wärmeleistung ließe sich mit dieser Maßnahme reduzieren.

Fig. 5 zeigt eine weitere mögliche Ausführungsform, bei der vier LED-Chips gestapelt werden. Die einzelnen Chips sind jeweils um 22,5° gegeneinander verdreht. Somit wird beispielsweise die Mischung von vier verschiedenen Wellenlängen oder jeweils die Erzeugung einer einzelnen Wellenlänge aus vier verschiedenen möglichen Wellenlängen sowie jede beliebige Kombination möglich. Durch die Verdrehung der Chips um jeweils 22,5° wird erreicht, dass wiederum die überstehenden Dreiecksflächen eines der Chips nicht durch die anderen drei Chips verdeckt werden. Abgesehen von dem von in Fig. 4 dargestellten abweichenden Winkel der Verdrehung der einzelnen Chips des LED-Stapels treffen die im Zusammenhang mit der in Fig. 4 dargestellten Ausführungsform genannten Vorteile und Erwägungen auch auf die Ausführungsform gemäß Fig. 5 zu.

Die Figuren 6 und 7 stellen jeweils weitere mögliche Ausführungsformen des erfindungsgemäßen LED-Stapels dar.

Aus Fig. 6 ist, ähnlich wie Fig. 1, ein LED-Stapel ersichtlich, bei dem die beiden unteren LED-Chips 12 und 14 jeweils gleich groß und um 45° gegeneinander verdreht sind. Der obere LED-Chip 16 überragt in dieser Ausführungsform jedoch den Chip 14 nicht, ist aber gegenüber diesem auch um 45° verdreht. Insofern ist die Kantenlängen des oberen Chips 16 das 0,707-fache der Kantenlänge der Chips 12 bzw. 14. Dadurch ergibt sich für LED-Chip 16 eine Chipfläche, die etwa 50 % der Größe der LED-Chips 12 oder 14 beträgt.

Fig. 7 stellt einen LED-Stapel aus 4 Chips dar, die je um 45° gegeneinander verdreht sind. Der LED-Chip 14, der auf dem Chip 12 befestigt ist, überragt diesen nicht. Somit ist die Fläche des Chips 14 halb so groß wie die Fläche des Chips 12. Chip 16 hat dieselbe Chipgröße wie Chip 14, seine Ecken stehen also über Chip 14 hinaus. Der oberste Chip 17 überragt seinerseits den Chip 16 nicht, hat insofern also eine gegenüber Chip 14 bzw. 16 nochmals um den Faktor 0,5 verringerte Chipgröße. Verglichen mit dem untersten Chip 12 beträgt die Fläche des obersten Chips 17 etwa 25 % der Fläche des Chips 12.

Aus Fig. 8 ist ein angedeuteter Strahlenverlauf in der seitlichen Schnittdarstellung eines LED-Stapels gemäß Fig. 1 ersichtlich. Die Lichtemission geht von der aktiven Schicht 90 des Chips 14 aus. Die rückwärtig abgegebene Strahlung 92 wird am Substrat 66, die seitlich austretende Strahlung 94 an dem Reflektor 80 reflektiert und jeweils nach vorn geworfen.

Durch die in den Figuren 6 und 7 dargestellten Ausführungsformen wird deutlich, dass die Anordnung und Größe der LED-Chips in den Stapeln in weiten Grenzen an die Erfordernisse anpassbar sind. Weitere Kombinationen von LED-Chips mit unterschiedlichen Größen sowie deren Winkel, mit denen sie gegeneinander verdreht sind, sind möglich, je nach den Erfordernissen wie die benötigten Spektralfarben, Strahlungsleistung usw.

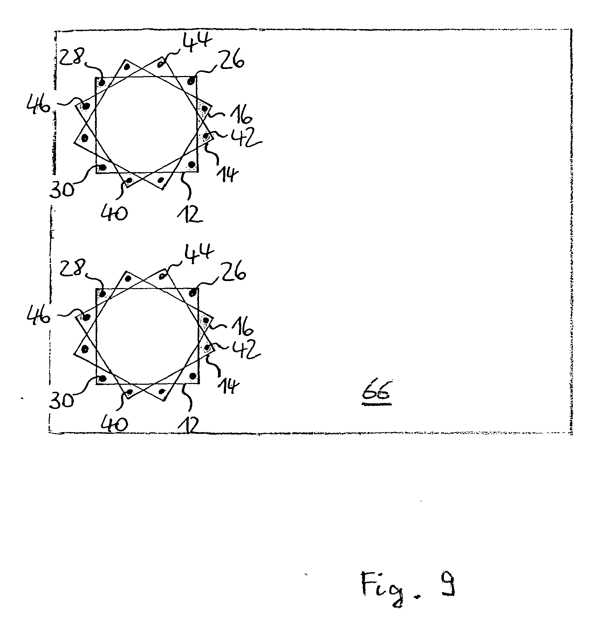

Fig. 9 zeigt die beispielhafte Anordnung zweier LED-Chips 12 auf einem gemeinsamen Substrat 66, wobei es sich versteht, dass eine derartige Anordnung bei allen Ausführunsgformen möglich ist.

In den Figuren sind jeweils quadratische LED-Chips dargestellt, da diese preisgünstig erhältlich sind. Es versteht sich, dass auch jede andere Chipgeometrie Verwendung finden kann.

## Patentansprüche

1. Lichtemissionsvorrichtung, mit mindestens zwei lichtemittierenden Halbleiterchips (12, 14, 16) und einem Substrat (66), wobei mindestens ein erster Halbleiterchip (12) auf dem Substrat (66) und auf dem ersten Halbleiterchip (12) wenigstens ein weiterer Halbleiterchip (14) angebracht ist,
**dadurch gekennzeichnet, dass** die
aufeinander angebrachten Halbleiterchips (12, 14; 14, 16) gegeneinander verdreht sind, so dass der jeweils darunterliegende Halbleiterchip im Wesentlichen dreieckförmige freie Emissionsflächen aufweist.

2. Lichtemissionsvorrichtung nach Anspruch 1, **dadurch gekennzeichnet, dass** die Fläche der weiteren Halbleiterchips (12, 14; 14, 16) mit zunehmendem Abstand vom Substrat (66) abnimmt.

3. Lichtemissionsvorrichtung nach Anspruch 1 oder 2, **dadurch gekennzeichnet, dass** der weitere als relativ oberer Halbleiterchip (14) eine nach oben weisende Fläche des ersten als relativ unterem oder des darunterliegenden Halbleiterchips (12) frei lässt und dass mindestens die freigelassene Fläche des unteren oder darunterliegenden Halbleiterchips (12) und mindestens ein Teil der Fläche des weiteren Halbleiterchips (16) lichtemittierend ist, wobei der untere Halbleiterchip (12) auf dem Substrat (66) angebracht ist.

4. Lichtemissionsvorrichtung nach Anspruch 1, 2 oder 3 **dadurch gekennzeichnet, dass** sich seitliche Lichtemissionsflächen (50, 52, 56, 58) seitlich an den Chips erstrecken, die zueinander versetzt sind.

5. Lichtemissionsvorrichtung nach einem der vorhergehenden Ansprüche, **dadurch gekennzeichnet, dass** sich eine seitliche Lichtemissionsfläche (50, 52) des weiteren Halbleiterchips (14), bezogen auf eine seitliche Lichtemissionsfläche (56, 58) des unteren oder darunterliegenden Halbleiterchips (12), zur Mitte des Halbleiterchips (14) hin verlagert, erstreckt.

6. Lichtemissionvorrichtung nach einem der vorhergehenden Ansprüche, **dadurch gekennzeichnet, dass** die Halbleiterchips (12, 14, 16) im Wesentlichen pyramidenförmig zueinander aufgebaut sind.

7. Lichtemissionsvorrichtung nach einem der vorhergehenden Ansprüche, **dadurch gekennzeichnet, dass** die Halbleiterchips (12, 14, 16) für emittierte Strahlung mindestens teilweise durchlässig sind.

8. Lichtemissionsvorrichtung nach einem der vorhergehenden Ansprüche, **dadurch gekennzeichnet, dass** die Lichtemissionsvorrichtung einen Reflektor aufweist, der unterhalb des unteren Halbleiterchips (12) angebracht ist, und dass zwischen dem unteren, einem mittleren und dem und oberen Halbleiterchip (16) kein Reflektor vorgesehen ist.

9. Lichtemissionsvorrichtung nach einem der vorhergehenden Ansprüche, **dadurch gekennzeichnet, dass** die Lichtemissionsvorrichtung eine Mehrzahl von Halbleiterchips (12, 14, 16) aufweist und ein Reflektor unterhalb des untersten Halbleiterchips (12) angebracht ist, der sich insbesondere seitlich über den Halbleiterchip hinaus erstreckt.

10. Lichtemissionsvorrichtung nach einem der vorhergehenden Ansprüche, **dadurch gekennzeichnet, dass** die Halbleiterchips (12, 14, 16) über eine reflexionsfreie Klebeschicht miteinander verbunden sind, die eine Wärmeleitfähigkeit aufweist, die etwa so groß wie die Wärmeleitfähigkeit der Halbleiterchips (12, 14, 16) ist, wobei die Stärke der Klebeschicht insbesondere weniger als 100 µm und bevorzugt weniger als 50 µm beträgt.

11. Lichtemissionsvorrichtung nach einem der vorhergehenden Ansprüche, **dadurch gekennzeichnet, dass** mehrere Halbleiterchips (12, 14, 16), die Licht unterschiedlicher spektraler Wellenlängen ausstrahlen, aufeinander angeordnet sind.

12. Lichtemissionsvorrichtung nach einem der vorhergehenden Ansprüche, **dadurch gekennzeichnet, dass** die Halbleiterchips (12, 14, 16) mindestens teilweise zueinander elektrisch in Reihe geschaltet sind.

13. Lichtemissionsvorrichtung nach einem der vorhergehenden Ansprüche, **dadurch gekennzeichnet, dass** die Halbleiterchips (12, 14, 16) mindestens teilweise zueinander elektrisch parallel geschaltet sind.

14. Lichtemissionsvorrichtung nach einem der vorhergehenden Ansprüche, **dadurch gekennzeichnet, dass** die Halbleiterchips (12, 14, 16) auf ihrer Oberseite im Bereich der freigelassenen Fläche mindestens ein elektrisches Anschlussfeld aufweisen.

15. Lichtemissionsvorrichtung nach einem der vorhergehenden Ansprüche, **dadurch gekennzeichnet, dass** das Substrat (66) elektrisch isolierend ist und eine Reflexionsschicht trägt.

16. Lichtemissionsvorrichtung nach einem der Ansprüche 1 bis 13, **dadurch gekennzeichnet, dass** der unterste Halbleiterchip (12) auf einen elektrisch mindestens halbleitfähigen Substrat (66) aufgebracht ist und dass eine elektrische Anschlußfläche des untersten Halbleiterchip (12) durch das Substrat gebildet ist.

17. Lichtemissionsvorrichtung nach einem der vorhergehenden Ansprüche, **dadurch gekennzeichnet, dass** der obere Halbleiterchip (16) kleiner als der untere oder darunterliegende Halbleiterchip (12) ist, wobei insbesondere der Größenunterschied etwa der doppelten Stärke jedes Halbleiterchips (12, 14, 16) entspricht.

18. Lichtemissionsvorrichtung nach einem der vorhergehenden Ansprüche, **dadurch gekennzeichnet, dass** aufeinander angebrachte Halbleiterchip (12, 14, 16) gegeneinander verdreht sind, insbesondere in einem Winkel von insbesondere 45°.

19. Lichtemissionsvorrichtung nach einem der vorhergehenden Ansprüche, **dadurch gekennzeichnet, dass** das Substrat einen Vorsprung aufweist, dessen Abmessungen im Wesentlichen den Abmessungen des unteren Halbleiterchips (12) entsprechen und auf dem der untere Halbleiterchip (12) angebracht ist.

20. Lichtemissionsvorrichtung nach einem der vorhergehenden Ansprüche, **dadurch gekennzeichnet, dass** ein Zusatzreflektor, insbesondere ein Ringreflektor (80), die aufeinander angebrachten Halbleiterchips (12, 14, 16) umgibt, dessen Ausrichtung in an sich bekannter Weise schräg oder parabolisch ist und der die seitliche Lichtemission der Halbleiterchips (12, 14, 16) nach vorne reflektiert.

21. Lichtemissionsvorrichtung nach einem der vorhergehenden Ansprüche, **dadurch gekennzeichnet, dass** eine Sammellinse vor den Halbleiterchips (12, 14, 16) angebracht ist, die insbesondere auf dem Reflektor (80) abgestützt ist.

22. Lichtemissionsvorrichtung nach Anspruch 20, **dadurch gekennzeichnet, dass** der Raum zwischen den Halbleiterchips (12, 14, 16) und der Unterseite der Sammellinse von einer durchsichtigen oder durchscheinende, flüssige oder gelförmige lichtdurchlässigen Substanz, insbesondere Silikongel, gefüllt ist.

23. Lichtemissionsvorrichtung nach einem der vorhergehenden Ansprüche, **dadurch gekennzeichnet, dass** die elektrischen Anschlussflächen (26, 28, 20) Freiflächen (20, 22, 24) einer Printplatte benachbart sind, mit welchen Sie elektrisch über Bonddrähte verbunden sind.

24. Lichtemissionsvorrichtung nach einem der vorhergehenden Ansprüche, **dadurch gekennzeichnet, dass** sich eine Printplatte die Halbleiterchips (12, 14, 16) mindestens teilweise umgebend seitlich neben diesen erstreckt und insbesondere mit Leiterbahnen unterhalb eines Ringreflektors (80) verläuft.

25. Lichthärtgerät mit mindestens einer Lichtemissionsvorrichtung nach einem der vorhergehenden Ansprüche, insbesondere zum Aushärten von lichtpolymerisierbaren Dentalmassen.
